(19) Europäisches Patentamt
European Patent Office
Office européen des brevets

(11) **EP 1 756 882 B1**

(12) **FASCICULE DE BREVET EUROPEEN**

(45) Date de publication et mention
de la délivrance du brevet:
**10.09.2008 Bulletin 2008/37**

(21) Numéro de dépôt: **05778186.6**

(22) Date de dépôt: **16.06.2005**

(51) Int Cl.:
***H01L 41/24*** *(2006.01)*

(86) Numéro de dépôt international:
**PCT/FR2005/050453**

(87) Numéro de publication internationale:
**WO 2006/003342 (12.01.2006 Gazette 2006/02)**

(54) **PROCEDE DE PREPARATION DE MATERIAUX PIEZOELECTRIQUES**

VERFAHREN ZUR HERSTELLUNG VON PIEZOELEKTRISCHEN MATERIALIEN

METHOD FOR PREPARING PIEZOELECTRIC MATERIALS

(84) Etats contractants désignés:
**AT BE BG CH CY CZ DE DK EE ES FI FR GB GR HU IE IS IT LI LT LU MC NL PL PT RO SE SI SK TR**

(30) Priorité: **17.06.2004 FR 0451289**

(43) Date de publication de la demande:
**28.02.2007 Bulletin 2007/09**

(73) Titulaire: **COMMISSARIAT A L'ENERGIE ATOMIQUE**
**75015 Paris (FR)**

(72) Inventeurs:
• **BOY, Philippe**
**F-37300 JOUE LES TOURS (FR)**
• **EHRHART, Gilles**
**F-59000 LILLE (FR)**
• **BELLEVILLE, Philippe**
**F-37000 TOURS (FR)**

(74) Mandataire: **Poulin, Gérard et al**
**Brevatome**
**3, rue du Docteur Lancereaux**
**75008 Paris (FR)**

(56) Documents cités:
**DE-C- 4 416 245**      **DE-C- 19 744 630**

• **DOREY R A ET AL: "Effect of sintering aid and repeated sol infiltrations on the dielectric and piezoelectric properties of a PZT composite thick film" JOURNAL OF THE EUROPEAN CERAMIC SOCIETY, ELSEVIER SCIENCE PUBLISHERS, BARKING, ESSEX, GB, vol. 22, no. 16, décembre 2002 (2002-12), pages 2921-2926, XP004387511 ISSN: 0955-2219**
• **KHOLKIN A L ET AL: "PZT-based piezoelectric composites via a modified sol-gel route" JOURNAL OF THE EUROPEAN CERAMIC SOCIETY, ELSEVIER SCIENCE PUBLISHERS, BARKING, ESSEX, GB, vol. 21, no. 10-11, 2001, pages 1535-1538, XP004301715 ISSN: 0955-2219**
• **DUVAL F F C ET AL: "Lead germanium oxide sinter-assisted PZT composite thick films" JOURNAL OF THE EUROPEAN CERAMIC SOCIETY, ELSEVIER SCIENCE PUBLISHERS, BARKING, ESSEX, GB, vol. 23, no. 11, octobre 2003 (2003-10), pages 1935-1941, XP004424289 ISSN: 0955-2219**

EP 1 756 882 B1

# Description

## DOMAINE TECHNIQUE

La présente invention a pour objet un procédé de préparation de matériaux piézoélectriques en céramique oxyde par voie sol-gel.

Les matériaux piézoélectriques sont des matériaux diélectriques particuliers, qui permettent de transformer l'énergie d'une déformation élastique en énergie électrique. Plus précisément, ces matériaux présentent une capacité à se polariser, lorsqu'ils sont contraints mécaniquement, la charge apparaissant à leur surface étant proportionnelle à la déformation engendrée. De tels matériaux peuvent trouver leur application dans des domaines aussi divers que la conception de briquets piézoélectriques, de transducteurs et actuateurs, de générateurs ou de récepteurs d'ultrasons, d'interfaces tactiles. Parmi les matériaux piézoélectriques, on trouve une sous-classe formée par les matériaux pyroélectriques, qui présentent, de plus, une polarisation naturelle le long d'un axe privilégié, appelée polarisation spontanée. L'importance de cette polarisation dépend fortement de la température d'où leur dénomination. Ces matériaux pyroélectriques trouvent leur application dans le domaine de la détection, plus particulièrement dans le domaine de la détection infrarouge.

Enfin, parmi les matériaux piézoélectriques, on peut encore citer les matériaux ferroélectriques, qui ont la particularité de pouvoir se polariser selon deux directions ou plus, chaque direction étant équiprobable. Par application d'un champ électrique, on peut faire basculer la polarisation d'une direction à l'autre. C'est ce phénomène, qui est en grande partie responsable des propriétés piézoélectriques de ces matériaux, le basculement modifiant localement la structure cristalline de ces matériaux et rendant l'effet beaucoup plus important que chez les autres matériaux. Ces matériaux trouvent naturellement leur application dans le domaine des actionneurs, des transducteurs.

## ÉTAT DE LA TECHNIQUE ANTÉRIEURE

Les matériaux piézoélectriques ayant fait l'objet de nombreux travaux ces dernières années se présentent sous la forme de matériaux en céramique oxyde. On peut citer, comme matériaux piézoélectriques en céramique oxyde développés ces dernières années, des matériaux à structure pérovskite, comme le zircono-titanate de plomb (intitulé PZT), le titanate de baryum et de strontium (intitulé BST), le titanate de plomb, de niobium et de zinc (intitulé PZNT), le niobate de magnésium et de plomb (intitulé PMN), le titanate de plomb (intitulé PT), le niobate de potassium et de calcium, le titanate de bismuth et de potassium (intitulé BKT), le titanate de bismuth et de strontium (intitulé SBT).

Ces matériaux piézoélectriques de type céramique oxyde peuvent être obtenus par des procédés en phase vapeur, en phase plasma, en phase solide ou encore en phase liquide.

Pour les procédés se déroulant en phase vapeur, le procédé le plus communément utilisé est l'évaporation, dans laquelle la céramique à déposer est placée dans un creuset porté à une température telle que des vapeurs se forment et se recondensent sous forme d'un revêtement ou couche sur un substrat refroidi.

Pour les procédés mettant en jeu une phase plasma, on peut citer la pulvérisation cathodique. Selon cette technique, le matériau céramique à déposer est bombardé par des ions générés par un plasma. L'énergie cinétique des ions du plasma est transférée aux atomes du matériau à déposer qui sont projetés à grande vitesse sur le substrat à revêtir et se déposent sur celui-ci sous forme d'un revêtement ou couche.

Pour les procédés se déroulant en phase solide, on peut citer la décomposition de composés organo-métalliques, qui consiste à décomposer thermiquement ces composés précurseurs de céramiques à une température suffisante pour engendrer, d'une part, une élimination des produits organiques formés durant cette décomposition et d'autre part, une céramisation.

On peut citer encore une technique mettant en oeuvre une dispersion solide/liquide consistant à mélanger une poudre céramique à un solvant organique, à déposer cette dispersion sous forme de couche sur un substrat et à traiter thermiquement cette couche. Une autre technique consiste à fritter une poudre céramique sur un substrat avec ajout de colle. Pour ces deux techniques, l'épaisseur des couches ne peut être contrôlée précisément.

Ces procédés (phase vapeur, phase plasma et phase solide) nécessitent toutefois la mise en oeuvre de températures très élevées (généralement supérieures à 1000°C) et la mise en place d'un appareillage réfractaire).

Une voie permettant de contourner ces inconvénients est une voie se déroulant uniquement en phase liquide, qui n'est autre que le procédé sol gel.

Le procédé sol-gel consiste, dans un premier temps, à préparer une solution contenant des précurseurs des céramiques oxydes à l'état moléculaire (composés organométalliques, sels métalliques), formant ainsi un sol (également appelé solution sol-gel). Dans un deuxième temps, ce sol est déposé, sous forme d'un film, sur un substrat. Au contact de l'humidité ambiante, les précurseurs s'hydrolysent et se condensent pour former un réseau d'oxyde emprisonnant le solvant, ce qui aboutit à un gel. La couche de gel formant un film est ensuite traitée thermiquement de façon à former un film en céramique. Le procédé sol-gel présente de nombreux avantages par rapport aux procédés explicités plus haut :

- il permet de réaliser des revêtements sur des surfaces complexes ;
- il permet d'obtenir des dépôts homogènes en composition et en épaisseur ;
- du fait que le mélange des espèces se déroule à l'échelle moléculaire, il est possible de réaliser par ce procédé des oxydes complexes comportant, par exemple, trois éléments ou plus.

Toutefois, le dépôt de couches par voie sol-gel permet difficilement d'atteindre des épaisseurs supérieures à 1 µm.

Or la diversité des applications concernant les matériaux piézoélectriques implique que ces matériaux présentent une très large gamme d'épaisseurs, qui peut aller de la centaine de nanomètres à la centaine de microns. Pour atteindre des épaisseurs supérieures à 1 µm, certains auteurs ont proposé d'utiliser comme solution de dépôt une dispersion comprenant en tant que milieu continu de dispersion une solution sol-gel précurseur de la céramique oxyde piézoélectrique et en tant que phase dispersée une poudre de ladite céramique oxyde piézoélectrique.

Des procédés connus sont décrits par

- R.A. Dorey et al. dans "Effect of sintering aid and repeated sol infiltrations on the dielectric and piezoelectric properties of a PZT composite thick film", Journal of the European Ceramic Society 22 (2002), pages 2921-2926

- A.L. Kholkin et al. dans "PZT-based composites via a modified sol-gel route", Journal of the European Ceramic Society 21 (2001), pages 1535-1538

- F.F.C. Duval et al. dans "Lead germanium oxide sinter-assisted PZT composite thick films", Journal of the European Ceramic Society 23 (2003), pages 1935-1941.

Ainsi, D.A Barrow et al. dans « Surface and Coatings Technology 76-77 (1995), pages 113-118 [1] décrivent un procédé de préparation d'un revêtement piézoélectrique en zircono-titanate de plomb (PZT) présentant une épaisseur supérieure ou égale à 10 µm. Ce procédé comprend le dépôt sur un substrat de plusieurs couches d'une solution sol-gel précurseur de céramique PZT comprenant une dispersion d'une poudre de ladite céramique, suivi d'un traitement thermique approprié. A l'issue de ce procédé, le revêtement obtenu présente du fait de la nature composite de la

solution utilisée de nombreuses irrégularités de surface ainsi qu'une porosité très importante, ce qui a pour conséquence d'engendrer des matériaux présentant de faibles constantes diélectriques.

Afin de remédier aux inconvénients cités ci-dessus, les auteurs Dorey et al. dans Integrated Ferroelectrics, 2002, Vol.50, pp.111-119 [2], ont proposé de faire suivre chaque étape de dépôt de couche de la dispersion telle que définie plus haut, après traitement thermique de ladite couche, par une étape d'imprégnation de ladite couche par une solution sol-gel dénuée de poudre. Si ces procédés permettent d'améliorer la permittivité relative des matériaux obtenus, ils ne semblent pas avoir une influence prépondérante sur la valeur de la constante piézoélectrique $d_{33}$, laquelle ne dépasse pas 70 pC/N.

Les inventeurs se sont donc fixés pour objectif de fournir un procédé qui permette d'obtenir des matériaux piézoélectriques à faible rugosité présentant une constante piézoélectrique plus élevée que celle des matériaux de l'art antérieur et également plus simple dans sa mise en oeuvre.

## EXPOSÉ DE L'INVENTION

Les inventeurs ont atteint l'objectif qu'ils s'étaient fixé par la présente invention qui a pour objet un procédé de préparation d'un matériau à base de céramique(s) oxyde(s) piézoélectrique(s) comprenant successivement les étapes suivante :

a) déposer par voie liquide sur un substrat une couche d'une dispersion comprenant une poudre d'une céramique oxyde et une solution sol-gel précurseur d'une céramique oxyde, la poudre de céramique oxyde étant piézoélectrique et/ou la solution sol-gel étant précurseur d'une céramique oxyde piézoélectrique ;
b) répéter a), une ou plusieurs fois, de manière à obtenir un empilement d'au moins deux couches ;
c) traiter thermiquement lesdites couches en vue de les transformer en la (les) céramique(s) correspondante(s) ;
d) imprégner par trempage-retrait l'empilement obtenu en c) par une solution sol-gel identique ou différente de celle utilisée dans l'étape a) ;
e) répéter l'étape d) une ou plusieurs fois ;
f) traiter thermiquement ledit empilement, en vue de transformer la solution sol-gel imprégnant l'empilement en la céramique correspondante.

Le procédé de l'invention permet de s'affranchir d'un certain nombre d'inconvénients des procédés de l'art antérieur et notamment ceux découlant du document [2] mentionné ci-dessus. En effet, l'étape d'imprégnation par une solution sol-gel de la totalité de l'empilement et non couche par couche, contribue à simplifier considérablement les procédés de l'art antérieur. De plus, les auteurs ont pu mettre en évidence une amélioration considérable des propriétés piézoélectriques des matériaux obtenus par le procédé de l'invention.

Selon l'invention, le procédé comprend, dans un premier temps, une étape de dépôt sur un substrat d'une couche d'une dispersion comprenant une poudre d'une céramique oxyde et une solution sol-gel précurseur d'une céramique oxyde, la poudre de céramique oxyde étant piézoélectrique et/ou la solution sol-gel étant précurseur d'une céramique oxyde piézoélectrique, ce dépôt s'effectuant par voie liquide.

On précise que, selon une première possibilité, soit la poudre de céramique oxyde est piézoélectrique, soit la solution sol-gel est précurseur d'une céramique oxyde piézoélectrique ou vice-verça. Selon une deuxième possibilité, à la fois la poudre de céramique oxyde est piézoélectrique, et la solution sol-gel est précurseur d'une céramique oxyde piézoélectrique. Dans ce cas, la poudre de céramique oxyde piézoélectrique peut être de composition identique à la céramique oxyde piézoélectrique qui résultera du traitement thermique de la solution sol-gel précurseur.

Parmi les techniques de dépôt par voie liquide, l'on peut envisager :

- le trempage-retrait (connu sous la terminologie anglaise « dip-coating ») ;
- l'enduction centrifuge (connue sous la terminologie anglaise « spin-coating ») ;
- l'enduction laminaire (connue sous la terminologie anglaise « laminar-flow-coating ou meniscus coating ») ;
- la projection pneumatique (connue sous la terminologie anglaise « spray-coating ») ;
- l'enduction à la racle (connue sous la terminologie anglaise « doctor blade coating »).

Parmi ces techniques, la technique la plus avantageuse est la technique du trempage-retrait, qui permet d'obtenir d'excellents résultats et qui permet notamment de faire des dépôts sur des substrats à forme complexe.

Le substrat sur lequel l'on dépose la couche de dispersion peut être de différents types.

Avantageusement, ce substrat ne doit pas contaminer la couche déposée, par migrations d'ions par exemple, lors des traitements thermiques et doit permettre une bonne adhérence de la couche. Avantageusement, sa température de ramollissement doit être supérieure à la température des traitements thermiques des couches déposées et son coefficient de dilatation thermique doit être compatible avec celui desdites couches pour limiter les effets de contrainte lors du recuit.

En particulier, il peut être choisi parmi les substrats en acier inoxydable, en acier comprenant du nickel, en silicium éventuellement métallisé, en aluminium, en alumine, en titane, en carbone, en verre ou en polymère.

Notamment, lorsque les substrats sont à base de métal, tels que les substrats en acier, en aluminium ou en titane, il peut être avantageux de déposer sur la face du substrat, (qui sert de support au dépôt de la couche de dispersion), une couche dense d'un oxyde choisi, par exemple, parmi $SiO_2$, $Ta_2O_5$, $ZrO_2$, $Al_2O_3$, $TiO_2$, PZT, BST et des combinaisons de celles-ci.

Cette couche assurera le rôle d'une couche barrière et empêchera ainsi la diffusion lors du traitement thermique des atomes appartenant au substrat vers l'empilement de couches. Cette couche servant de barrière peut être obtenue par dépôt sur le substrat d'une solution sol-gel précurseur de la (les) céramique(s) oxyde(s) constitutif (s) de cette couche, le dépôt d'une telle solution sol-gel pouvant se faire selon l'une des techniques de dépôts par voie liquide mentionnées ci-dessus.

La dispersion que l'on dépose sous forme de couches sur le substrat est obtenu classiquement en dispersant une poudre de céramique oxyde dans une solution sol-gel précurseur d'une céramique oxyde, la poudre de céramique oxyde étant piézoélectrique et/ou la solution sol-gel étant précurseur d'une céramique oxyde piézoélectrique, la poudre constituant ainsi la phase de dispersion tandis que la solution sol-gel constitue le milieu continu de dispersion.

Avantageusement, la poudre de céramique oxyde est piézoélectrique et la solution sol-gel est également précurseur d'une céramique oxyde piézoélectrique.

Lorsque que la poudre de céramique oxyde est une poudre de céramique piézoélectrique, elle est choisie avantageusement parmi les poudres de zircono-titanate de plomb (intitulé PZT), de titanate de baryum et de strontium (intitulé BST), de titanate de plomb, de niobium et de zinc (intitulé PZNT), de niobate de magnésium et de plomb (initulé PMN), de titanate de plomb (intitulé PT), de niobate de potassium et de calcium, de titanate de bismuth et de potassium (intitulé BKT), de titanate de bismuth et de strontium (intitulé SBT).

Quant à la solution sol-gel précurseur de céramique oxyde piézoélectrique, celle-ci est avantageusement précurseur de céramiques choisies parmi le zircono-titanate de plomb (intitulé PZT), le titanate de baryum et de strontium (intitulé BST), le titanate de plomb, de niobium et de zinc (intitulé PZNT), le niobate de magnésium et de plomb (intitulé PMN), le titanate de plomb (intitulé PT), le niobate de potassium et de calcium, le titanate de bismuth et de potassium (intitulé BKT), le titanate de bismuth et de strontium (intitulé SBT).

Lorsque la poudre de céramique oxyde est piézoélectrique, et la solution sol-gel est précurseur d'une céramique oxyde piézoélectrique, la céramique oxyde constitutif de la poudre peut être de composition identique à celle de la céramique oxyde qui résultera du traitement thermique de la solution sol-gel dans laquelle la poudre est mise en dispersion.

La poudre selon l'invention est une poudre qui peut être disponible commercialement ou encore qui peut être préparée préalablement.

Ainsi, la poudre de céramique oxyde peut être préparée par des voies classiques de préparation des poudres, parmi lesquelles on peut citer la préparation par métallurgie des poudres, la préparation par voie liquide, telle que la technique sol-gel.

Selon la technique sol-gel, les poudres sont ainsi obtenues à partir de précurseurs moléculaires métalliques ajoutés à un milieu comprenant un solvant organique ou aqueux. Ces précurseurs moléculaires métalliques comprennent les éléments métalliques qui sont destinés à entrer dans la composition de la céramique oxyde constitutif de la poudre. Ces précurseurs peuvent être des alcoxydes métalliques, des sels métalliques. Le milieu comprenant un solvant organique est généralement un milieu alcoolique, la fonction de ce milieu étant de solubiliser les précurseurs moléculaires. Le milieu peut être également un milieu aqueux.

Selon cette technique, deux voies sont envisageables :

- la voie polymérique ; et
- la voie colloïdale.

Selon la voie polymérique, la solution obtenue par solubilisation des précurseurs moléculaires dans ledit milieu organique est ensuite hydrolysée par ajout, généralement, d'une solution aqueuse acide ou basique, de façon à ce que les précurseurs susmentionnés se condensent et forment un gel, c'est-à-dire un réseau tridimensionnel amorphe solide qui emprisonne le milieu organique. L'étape suivante consiste à sécher le gel de manière à éliminer le solvant interstitiel, à l'issue de laquelle on récupère un gel sec (appelé xérogel) suivi d'un éventuel broyage de ce xérogel, si celui-ci se trouve sous une forme autre qu'une poudre. Selon la nature de la poudre à obtenir, il peut être nécessaire de mettre en oeuvre, après le séchage, des étapes de traitement thermique telles qu'une étape de calcination, afin d'éliminer les restes de composés organiques qui subsisteraient ainsi qu'une étape de recuit, destinée à cristalliser la poudre dans le système cristallin souhaité.

Selon la voie colloïdale, la solution obtenue par solubilisation ou dissolution des précurseurs moléculaires susmentionnés est hydrolysée, de façon à former une dispersion de petites particules d'oxydes. Ensuite, l'on procède à une évaporation de solvant et à une calcination des particules d'oxydes obtenues, à l'issue de laquelle l'on obtient la poudre d'oxyde souhaitée.

Avantageusement, la poudre est préparée à partir de la solution sol-gel dans laquelle la poudre est dispersée ultérieurement pour constituer la dispersion.

Une variante faisant partie de la technique sol-gel consiste à préparer les poudres de céramique oxyde par chauffage de précurseurs en suspension ou en solution dans un milieu aqueux à une température et/ou à pression élevées. Les précurseurs sont généralement des composés inorganiques métalliques, tels que des sels métalliques, des oxydes métalliques, des composés organométalliques. Ils sont mis en contact avec un milieu aqueux, généralement dans un autoclave, et sous agitation, à une température de travail supérieure à la température d'ébullition de l'eau. Cette température est choisie de manière à permettre une décomposition des précurseurs susmentionnés et la réaction de formation de particules de céramiques oxydes souhaitées. Le chauffage peut être poursuivi pendant une durée pouvant être comprise de quelques minutes à une ou plusieurs heures, pendant laquelle la pression et la température sont maintenues. A l'issue de cette durée, le chauffage est arrêté et la température et la pression sont ramenées respectivement à la température ambiante et à la pression atmosphérique. Ensuite, le produit, se présentant sous forme d'une poudre d'oxyde, est récupéré, par exemple par filtration. Cette voie est qualifiée généralement de voie hydrothermale.

Les poudres utilisées dans le cadre de cette invention présentent avantageusement un diamètre moyen de particules allant de 10 nm à 100 $\mu$m. Avant incorporation dans la solution sol-gel mentionnée plus haut, elles peuvent être amenées à subir une étape de broyage, par exemple, par attrition, de manière à obtenir des grains plus fins.

La solution précurseur de céramique oxyde, dans laquelle est dispersée la poudre, est obtenue, comme son nom l'indique, par la technique sol-gel, plus précisément, par solubilisation ou dissolution dans un milieu organique d'un ou plusieurs précurseurs moléculaires tels que définis ci-dessus.

Selon l'invention, la poudre peut être incorporée dans la solution sol-gel à une teneur pouvant aller jusqu'à 80% en poids du poids total de la dispersion, de préférence à une teneur allant de 10 à 60% en poids. Cette teneur à incorporer peut être choisie aisément par l'homme du métier en fonction de l'épaisseur de couche souhaitée.

La dispersion préparée est ensuite déposée sous forme de couche par voie liquide (tel qu'explicité ci-dessus) sur un substrat tel que défini ci-dessus.

Le choix de la vitesse de dépôt est réalisé en fonction de l'épaisseur de la couche souhaitée. Généralement, l'épaisseur de chaque couche déposée va de 0,05 à 15 $\mu$m.

Dans le cas de la technique du tremprage-retrait, le substrat à recouvrir est plongé dans la dispersion préparée précédemment puis retiré à une vitesse prédéterminée. La vitesse de retrait se situe, généralement, entre 1 cm/min et 30 cm/min. Les techniques de dépôt par voie liquide comme l'enduction centrifuge, l'enduction laminaire ou le trempage-retrait présentent l'avantage de permettre un contrôle précis de l'épaisseur des couches déposées.

Cette étape de dépôt est répétée une ou plusieurs fois de manière à obtenir un empilement d'au moins deux couches et pouvant aller, par exemple, jusqu'à 50 couches. Le nombre de répétition de cette étape sera fixé par l'homme du métier en fonction de l'épaisseur d'empilement souhaité, l'épaisseur de l'empilement pouvant être supérieure à 1 $\mu$m.

Le procédé de l'invention comprend également une étape de céramisation par traitement thermique desdites couches, c'est-à-dire une étape de traitement thermique de la dispersion susmentionnée, en vue de transformer la solution sol-gel en la céramique correspondante.

Selon une première alternative, le traitement thermique peut être mise en oeuvre couche par couche. Dans ce cas, le traitement thermique comprend généralement successivement:

- une étape de séchage de la couche à une température appropriée pour obtenir une gélification de celle-ci ;

- une étape de calcination à une température appropriée pour obtenir une élimination des produits organiques compris dans la couche ;
- une étape de recuit à une température appropriée pour obtenir une cristallisation en céramique oxyde de la couche.

Ce traitement thermique est réitéré à chaque couche déposée, c'est-à-dire autant de fois qu'il y a de couches déposées.

Selon l'invention, l'on peut prévoir également de finaliser ce traitement thermique par une étape de recuit de l'ensemble de l'empilement.

Selon une seconde alternative, le traitement thermique peut se dérouler de la façon suivante :

- une étape de séchage de chaque couche déposée ;
- une étape de calcination de chaque couche déposée ;
- une étape de recuit toutes les n couches déposées, n allant de 2 jusqu'au nombre total de couches déposées.

Quelle que soit l'alternative envisagée, le séchage se déroule généralement à une température inférieure à 100°C. Ce séchage permet un rapprochement des précurseurs compris dans la solution sol-gel et une condensation de ceux-ci pour former un gel. Lors de cette condensation, des produits organiques sont libérés, tel que des alcools, des carbonates. L'étape de calcination, destinée à l'élimination des produits organiques et/ou inorganiques résultant de la condensation des précurseurs moléculaires, est généralement mise en oeuvre à des températures supérieures à 300°C, par exemple à une température de 340 à 380°C pour les produits organiques tels que les alcools et à une température allant de 380 à 400°C pour éliminer les carbonates le cas échéant.

Enfin, l'étape de recuit est généralement réalisée à une température supérieure à 550°C, de manière à cristalliser les couches.

Une fois l'empilement réalisé, le procédé selon l'invention prévoit une étape d'imprégnation de l'empilement complet par un solution sol-gel précurseur d'une céramique oxyde (dénuée de poudre), identique ou différente de celle utilisée dans la première étape, cette étape d'imprégnation étant répétée une ou plusieurs fois. Cette solution précurseur est de même nature ou différente de celle utilisée en tant que milieu continu de dispersion dans l'étape de dépôt susmentionnée.

Cette étape d'imprégnation est réitérée une ou plusieurs fois. L'homme du métier déterminera le nombre d'étapes d'imprégnation à mettre en oeuvre, de manière à obtenir un état de surface le moins rugueux possible. Par exemple, il pourra fixer le nombre d'étape d'imprégnation, de manière à obtenir, à l'issue de ces imprégnations, une rugosité de l'état de surface de l'empilement divisée par 10 par rapport à l'empilement non imprégné, la mesure de la rugosité étant effectuée par le biais d'un profilomètre. Ces étapes d'imprégnation sont effectuées par voie liquide, selon des techniques mentionnées ci-dessus, avec de préférence, la technique de trempage-retrait.

L'empilement ainsi imprégné est ensuite traité thermiquement, de façon à transformer la solution sol-gel précurseur imprégnant l'empilement en la céramique oxyde correspondante.

Selon une première alternative, le traitement thermique peut intervenir à la fin de chaque étape d'imprégnation. Dans ce cas, il comprend généralement une étape de séchage, généralement, à une température inférieure à 100°C, suivie d'une étape de calcination destinée à éliminer les produits organiques et éventuellement les carbonates issus de la transformation du solution en gel, cette étape se déroulant généralement à une température supérieure à 300°C, et enfin une étape de recuit destinée à cristalliser la céramique oxyde, cette étape se déroulant généralement à une température supérieure à 500°C.

Selon une seconde alternative, le traitement thermique peut comprendre successivement :

- une étape de séchage à chaque imprégnation;
- une étape de calcination à chaque imprégnation;
- une étape de recuit toutes les m imprégnations, m allant de 2 jusqu'au nombre total d'imprégnations.

Un matériau céramique présentant des propriétés piézoélectriques particulièrement intéressantes peut être le titanate de baryum et de strontium (intitulé BST), le titanate de plomb, de niobium et de zinc (intitulé PZNT), le niobate de magnésium et de plomb (intitulé PMN), le titanate de plomb (intitulé PT), le niobate de potassium et de calcium, le titanate de bismuth et de potassium (intitulé BKT), le titanate de bismuth et de strontium (intitulé SBT) et le zircono-titanate de plomb (PZT), en particulier le PZT répondant à la formule $PbZr_xTi_{(1-x)}O_3$ avec $0{,}45 \leq x \leq 0{,}7$.

Le procédé de l'invention s'applique donc tout naturellement à la conception de revêtements piézolélectriques en PZT.

Selon un mode de réalisation particulièrement avantageux, la solution sol-gel servant de milieu de dispersion pour la poudre sera utilisée comme solution sol-gel pour l'étape d'imprégnation et éventuellement comme solution sol-gel pour la préparation de la poudre.

Avantageusement, la solution sol-gel servant de milieu de dispersion pour la poudre et éventuellement de solution sol-gel pour l'étape d'imprégnation et éventuellement de solution sol-gel pour la préparation de la poudre peut être obtenue selon un procédé comprenant successivement les étapes suivantes :

- préparer, dans un milieu organique comprenant un solvant diol, une solution sol-gel précurseur d'une céramique PZT ;

- laisser au repos la solution sol-gel préparée précédemment pendant un temps suffisant nécessaire à l'obtention d'une solution sol-gel présentant une viscosité sensiblement constante en fonction du temps ;
- diluer la solution sol-gel ainsi obtenue à un taux prédéterminé de dilution avec le même solvant diol que celui utilisé dans la première étape ou un solvant différent miscible avec le solvant diol utilisé dans le cadre de la première étape.

Ce procédé a pour avantage de présenter une étape de stabilisation de la solution sol-gel (correspondant à l'étape de mise au repos). Cette stabilisation de la solution sol-gel est due notamment au fait de placer la solution sol-gel préparée lors de la première étape à température ambiante sans agitation pendant une durée adéquate pour obtenir une stabilisation de la viscosité de ladite solution. Cette étape correspond à un mûrissement de ladite solution. Pendant cette phase de mûrissement, les précurseurs moléculaires métalliques solubilisés (c'est-à-dire les précurseurs à base de plomb, de titane et de zirconium) condensent et se polymérisent jusqu'à un état d'équilibre. Cette polymérisation se traduit par une augmentation de la viscosité de la solution sol-gel, jusqu'à atteindre une valeur constante en fonction du temps, lorsque l'état d'équilibre est atteint. Cette phase de mûrissement est suivie, selon l'invention, d'une dilution, qui a pour effet d'ajuster définitivement à une valeur de viscosité la solution sol-gel résultant en garantissant ainsi une reproductibilité des dépôts de couches, à partir de solutions sol-gel réalisées dans les mêmes conditions opératoires ainsi qu'une répétabilité des dépôts de couches, du fait de la stabilité de la solution sol-gel obtenue par le procédé.

Selon ce procédé, dans un premier temps, l'on prépare une solution sol-gel précurseur de céramique PZT par mise en contact d'un ou plusieurs précurseurs moléculaires de plomb, de titane et de zirconium dans un milieu organique comprenant un solvant diol. Par exemple un mode particulier de réalisation d'une telle solution sol-gel consiste à préparer une solution sol-gel à base de plomb dans un solvant diol, par dissolution d'un précurseur moléculaire à base de plomb dans ce solvant diol, auquel on ajoute une solution sol-gel mixte à base de titane et de zirconium, ladite solution sol-gel mixte pouvant être préparée par dissolution d'un précurseur moléculaire à base de zirconium et d'un précurseur moléculaire à base de titane dans le même diol ou dans un solvant compatible avec ledit diol, à savoir un solvant miscible avec ledit diol, comme c'est le cas des alcools aliphatiques tels que le propanol. On précise, que la solution sol-gel à base de plomb est, de préférence, initialement en excès de 10 % par rapport à la stoechiométrie. Le mélange desdites solutions sol-gel peut être ensuite porté à reflux, sous agitation, à une température avoisinant la température d'ébullition du mélange réactionnel. Le reflux permet d'assurer, avantageusement, une homogénéisation des solutions sol-gel mélangés entre elles. De préférence, le solvant diol utilisé pour la préparation de la solution sol-gel à base de précurseurs moléculaires métalliques est un alkylène glycol, ayant un nombre d'atomes de carbone allant de 2 à 5. Ce type de solvant contribue à faciliter la solubilisation des précurseurs métalliques, notamment en jouant un rôle de chélatant en venant compléter la sphère de coordination du plomb, et le cas échéant du titane et du zirconium.

Selon un mode particulier de réalisation de l'invention, le solvant diol utilisé est l'éthylène glycol.

Selon l'invention, les précurseurs à base de plomb, de titane et de zirconium peuvent être de divers types, mais on préfère des précurseurs, qui sont disponibles dans le commerce et peu coûteux.
A titre d'exemple, on peut utiliser comme précurseur de plomb des sels organiques de plomb tels que des acétates, des sels minéraux de plomb tels que des chlorures ou encore des composés organométalliques du plomb comme des alcoolates comportant un nombre d'atomes de carbone allant de 1 à 4. De préférence, le précurseur de plomb utilisé est un sel organique hydraté tel que l'acétate de plomb trihydraté. Ce précurseur présente l'avantage d'être stable, très courant et bon marché. Toutefois, lors de l'utilisation d'un tel précurseur hydraté, il est préférable de procéder à une déshydratation de ce dernier. En effet, la présence d'eau lors du mélange des solutions sol-gel entre eux entraînerait une hydrolyse prématurée des précurseurs métalliques suivie d'une polymérisation. Il résulterait de cette étape de mélange non plus une solution sol-gel mixte à base de plomb, titane et zirconium mais un produit de mélange résultant sous forme de gel et, par conséquent, une difficulté de déposer le gel ainsi produit sous forme de films.
Par exemple, la déshydratation de l'acétate de plomb trihydraté peut s'effectuer par distillation de ce dernier dans le solvant diol utilisé pour effectuer le mélange des solutions sol-gel.
De préférence, les précurseurs de titane sont des alcoxydes, tels que l'isopropoxyde de titane. De même, les précurseurs de zirconium sont préférablement des alcoxydes, tels que le n-propoxyde de zirconium.

On note, qu'à l'issue de cette première étape, l'on peut obtenir une solution sol-gel dont la concentration est supérieure à 20 % en équivalent massique PZT, de préférence est d'environ 20 à environ 40 % en équivalent massique PZT, par exemple est de l'ordre de 26 %. On précise que les concentrations sont exprimées, en équivalent massique PZT, c'est-à-dire en pourcentage massique de céramique qui sera obtenue après traitement thermique par rapport à la masse totale de la solution sol-gel.

Ensuite, la solution sol-gel, obtenue à l'issue de la première étape de l'invention, subit une étape dite de mûrissement. Cette période consiste à placer au repose, comme nous l'avons explicité précédemment, la solution sol-gel, jusqu'à obtention d'une solution sol-gel présentant une viscosité constante en fonction du temps.

De préférence, la solution sol-gel obtenue au cours de la première étape est placée, à température ambiante, sans agitation, pendant une durée de 1 jour à 5 semaines.

Une fois la stabilisation de la viscosité de la solution sol-gel observée, ladite solution sol-gel est amenée à subir une dilution permettant d'accéder à des concentrations inférieures de la solution sol-gel précédemment préparée, ce qui facilite notamment l'utilisation ultérieure de cette solution sol-gel. Ainsi, en partant d'une solution sol-gel ayant une concentration supérieure à 20% en équivalent massique PZT, on peut diluer ainsi ladite solution sol-gel, pour obtenir par exemple, une solution sol-gel ayant une concentration de 1 à 20 % en équivalent massique PZT. Par exemple, en partant d'un sol concentré à 26 %, ladite solution sol-gel résultant de la seconde étape du procédé, on peut diluer la solution sol-gel de manière à obtenir une solution sol-gel à 20% en équivalent massique PZT. Cette dilution, à un taux déterminé, permet d'une part d'ajuster la viscosité à une valeur donnée et d'autre part d'utiliser cette solution sol-gel pour effectuer, notamment des dépôts de ladite solution sol-gel sous forme de couches.

Selon l'invention, le solvant de dilution doit être compatible avec le solvant de préparation de la solution sol-gel concentrée. Il peut être identique au solvant de préparation de ladite solution sol-gel ou peut être différent et choisi, de préférence, parmi les monoalcools aliphatiques.

La poudre de PZT est préparée, avantageusement, à partir d'une solution sol-gel dont la préparation est explicitée ci-dessous. Pour accéder à une poudre à partir d'une telle solution sol-gel, les étapes sont telles que celles explicitées plus haut, à savoir :

- une étape de gélification par hydrolyse de la solution sol-gel ;
- une étape de séchage à l'issue de laquelle l'on obtient un xérogel ;
- une étape de traitement thermique, pour obtenir une cristallisation du xérogel.

La dispersion préparée est ensuite, conformément à l'invention, déposée sous forme de couches sur un substrat.

Ce dépôt est effectué par voie liquide, telle l'enduction centrifuge, l'enduction laminaire, le trempage retrait, l'enduction à la racle, de préférence par trempage-retrait. Cette opération de dépôt est répétée une ou plusieurs fois de manière à obtenir un empilement de couches présentant l'épaisseur souhaitée.

Selon l'invention, les couches déposées sont amenées à subir un traitement thermique, de manière à obtenir un empilement de couches PZT cristallisées dans le système pérovskite. Ce traitement thermique peut être réalisé de diverses manières. Selon une première alternative, le traitement thermique comprend :

- une étape de séchage de la couche à une température appropriée pour obtenir une gélification de celle-ci, cette température étant généralement inférieure à 100°C ;
- une étape de calcination à une température appropriée pour obtenir une élimination des produits organiques compris dans la couche ;
- une étape de recuit à une température appropriée pour obtenir une cristallisation en céramique oxyde de la couche.

Ce traitement thermique est réitéré à chaque couche déposée, c'est-à-dire autant de fois qu'il y a de couches déposées.

L'on peut prévoir également de finalement ce traitement thermique par une étape de recuit de l'ensemble de l'empilement.

Selon une seconde alternative, l'étape de céramisation peut se dérouler de la façon suivante :

- une étape de séchage de chaque couche déposée ;
- une étape de calcination de chaque couche déposée ;
- une étape de recuit toutes les n couches déposées, n allant de 2 jusqu'au nombre total de couches déposées.

Quelle que soit l'alternative envisagée, le séchage est destinée à assurer une gélification desdites couches déposées. Plus précisément, cette étape est destinée à assurer l'évaporation d'une partie du solvant diol et du solvant de dilution utilisé dans la préparation de la solution sol-gel servant de milieu de dispersion continu. La température et la durée efficaces pour assurer le séchage peuvent être aisément déterminées par l'homme du métier à l'aide, par exemple, de la spectrophotométrie IR.

Une fois gélifiées, les couches subissent un traitement de calcination effectué à une température et un durée appropriées pour éliminer les produits organiques résultant des réactions de condensation lors de la formation du gel. La température de calcination est choisie de manière à permettre l'élimination des composés organiques de la couche déposée et en particulier les solvants de préparation et de dilution de la solution sol-gel et les composés organiques générés par la réaction des précurseurs moléculaires entre eux. Une température appropriée est une température pour laquelle l'on obtient des couches présentant un spectre infrarouge ne présentant plus de bandes d'absorption d'espèces carbonées.

Selon ce mode de réalisation particulier de l'invention, l'étape de calcination peut s'effectuer à une température comprise entre 300 et 390°C, pour une durée s'échelonnant de 1 à environ 30 minutes.

Enfin, les couches une fois calcinées sont amenées à subir une étape de recuit. Cette étape a pour but de permettre l'obtention de couches cristallisées PZT selon le système cristallin pérovskite. La température et la durée du recuit sont choisies de manière à obtenir cette cristallisation, vérifiable aisément par analyse structurale, telle que l'analyse par diffraction des rayons X. De préférence, le recuit est effectué à une température allant d'environ 600 à environ 800°C pour une durée comprise entre environ 1 minute et environ 4 heures.

Le recuit peut être mis en oeuvre à l'aide de différentes techniques. Par exemple, le recuit peut être réalisé dans un four classique ou encore par un mode de chauffage rapide, connu sous la la dénomination de « recuit thermique rapide » (correspondant à la terminologie anglaise « Rapid Thermal Annealing » (RTA)).

Une fois cristallisé, l'empilement de couches PZT est amené à subir plusieurs étapes d'imprégnation par une solution sol-gel préparée avantageusement de la même façon que celle utilisée pour constituer le milieu de dispersion continu. Ces étapes d'imprégnation se font par des techniques de dépôt par voie liquide telles que mentionnées ci-dessus, la technique de trempage-retrait étant la plus avantageuse.

Ensuite, l'empilement ainsi imprégné est amené à subir un traitement thermique destiné à permettre une céramisation de la solution sol-gel imprégnant l'empilement, ce traitement thermique étant similaire à celui explicité plus haut de manière générale. Avantageusement, les étapes d'imprégnation s'effectuent par trempage-retrait.

Ainsi, grâce au procédé de l'invention appliqué au PZT, et mettant en oeuvre une solution sol-gel stable, on a pu accéder à des matériaux piézoélectriques présentant d'excellentes propriétés, telles qu'une constante piézoélectrique de l'ordre de 600 pC.N$^{-1}$.

L'invention va maintenant être décrite par rapport à un exemple particulier de mise en oeuvre de l'invention, donné à titre illustratif et non limitatif.

**EXPOSÉ DÉTAILLÉ DE MODES DE RÉALISATION PARTICULIERS**

EXEMPLE 1

Cet exemple illustre la préparation d'un matériau piézoélectrique en PZT selon le procédé de l'invention.

Dans cet exemple sont préparés successivement :

- une solution sol-gel stable précurseur d'une céramique de composition nominale $Pb_1Zr_{0,52}Ti_{0,48}O_3$
- une poudre de céramique de composition nominale $Pb_1Zr_{0,52}Ti_{0,48}O_3$ ;
- une dispersion comprenant une poudre de céramique telle que définie ci-dessus et une solution sol-gel stable telle que définie ci-dessus.

1)Préparation d'une solution sol-gel stable précurseur d'une céramique oxyde PZT de composition nominale $(Pb_1Zr_{0,52}Ti_{0,48}O_3)$.

Dans cette partie, l'on illustre la préparation d'une solution précurseur de céramique PZT de formule $(Pb_1Zr_{0,52}Ti_{0,48}O_3)$ à partir d'un précurseur à base de plomb, l'acétate de plomb et à partir de précurseur de titane et de zirconium, sous forme d'alcoxydes.

Les alcoxydes de zirconium et de titane utilisés sont le n-propoxyde de zirconium commercial de concentration 70% en poids dans le propanol et l'isopropoxyde de titane. L'acétate de plomb est sous forme de trihydrate.

La viscosité est suivie à l'aide d'un viscosimètre à tube capillaire ou à cylindre tournant pour une température de l'ordre de 20°C.

Selon ce mode particulier de réalisation, la préparation de la solution sol-gel comporte une phase préliminaire de préparation d'une solution sol-gel déshydratée à base de plomb.

a) Préparation d'une solution sol-gel déshydratée à base de plomb.

Dans un ballon surmonté d'un montage de distillation, on pèse 751,07 g (1,98 mol) d'acétate de plomb trihydraté et 330 g (5,32 mol) d'éthylène glycol. On homogénéise le mélange à environ 70 °C de manière à permettre une dissolution de l'acétate de plomb. La température de la solution homogène obtenue est alors augmentée pour déshydrater le précurseur à base de plomb par distillation. On recueille 120 g de distillat et la concentration en plomb de la solution sol-gel est de l'ordre de 2,06 mol/kg.

b) Préparation de la solution sol-gel stable précurseur d'une céramique de formule $Pb Zr_{0,52}Ti_{0,48}O_3$.

Sous balayage d'argon, dans 264 g (330 ml) de n-propanol, on additionne sous agitation 225,13 g (0,792 mol) d'isopropoxyde de titane et on ajoute 401,52 g (0,858 mol) de n-propoxyde de zirconium à 70 % dans du n-propanol puis 458,7 g (412,5 ml) d'éthylène glycol. On laisse sous agitation 20 minutes à température ambiante.

Dans un tricol, on pèse 1.815 mol de solution sol-gel de précurseur de plomb préalablement préparé soit un excès de 10 % pour pallier la perte d'oxyde de plomb (PbO) lors du traitement thermique des films. Sous courant d'argon, on additionne rapidement la solution sol-gel à base de Ti/Zr sous forte agitation (600 t/min). A la fin de l'addition, on place un réfrigérant surmonté d'une garde dessicante et on arrête le balayage d'argon. On chauffe au reflux pendant 2 heures (101°C). Au cours de la montée en température, on diminue l'agitation à 250 tours/min. On obtient après reflux une solution sol-gel mixte concentrée qui a une concentration de l'ordre de 26 % en équivalent massique PZT. La solution sol-gel mixte est conservée à température ambiante sans agitation, jusqu'à obtention d'une viscosité constante en fonction du temps. Dans cet exemple de réalisation, la solution sol-gel mixte est maintenue 1 semaine à température ambiante sans agitation. Ensuite, la solution sol-gel mixte concentrée est diluée à 20 % en équivalent massique PZT, soit à une concentration de 0.75 M, par addition d'éthylène glycol.

La solution sol-gel obtenue après dilution présente une viscosité initiale de 3,34·10$^{-2}$ Pa·s (33,4 centipoises) (mesurée à 20°C). Une nouvelle mesure de viscosité de cette même solution sol-gel a été effectuée après 12 mois de vieillissement. Il a été mesuré une viscosité de 3,325·10$^{-2}$ Pa·s (33,25 centipoises) (mesure effectuée dans les mêmes conditions qu'initialement), soit une évolution totalement négligeable et non significative. On peut par conséquent conclure à l'absence de modification chimique de la solution durant ce laps de temps et donc à une parfaite stabilité dans le temps de cette solution.

2) Préparation d'une poudre de zircono-titanate de plomb (PZT).

On mélange, sous agitation, 60 g de solution sol-gel préparée au point 1) $Pb_{1,1}Zr_{0,52}Ti_{0,48}O_{3+\varepsilon}$ avec 20 g d'une solution basique d'ammoniaque à pH=10. Le mélange est mis à l'étuve (80°C) pendant 30 minutes. On obtient un gel que l'on chauffe ensuite à 200°C pendant 6 heures. A l'issue de ce chauffage, l'on obtient un solide jaune que l'on broie une première fois au mortier et que l'on calcine à 700°C au four pendant 4 heures.

3) Préparation de la dispersion

La poudre préalablement préparée est préalablement broyée au mortier avant d'être mélangée à la solution sol-gel PZT préparée au point 1). Les proportions sont de 50:50 en masse. La dispersion obtenue est sonifiée sous agitation pendant 20 minutes pour réduire la taille des grains et homogénéiser la dispersion. Le tout est ensuite placé sous agitation pendant au moins une journée.

3) Dépôt de la dispersion

On utilise un substrat souple en inox (6*3 cm$^2$) de 200 $\mu$m d'épaisseur. Il est préalablement nettoyé au savon et rincé à l'eau et à l'éthanol.
Le substrat est plaqué sur un support afin de protéger une face.
Le dépôt est réalisé par la technique de trempage-retrait (dip-coating selon la terminologie anglaise). Le substrat est trempé pendant 1 minute puis retiré à une vitesse de 10 cm.min$^{-1}$. Après avoir été libéré de son support, le film est ensuite placé sur une plaque chauffante à 50°C pendant 5 minutes puis 360°C pendant 5 minutes. La solution est maintenue sous agitation entre chaque dépôt. L'agitation est arrêtée lors du trempage retrait. Un traitement à 600°C pendant 10 minutes, dans un four, est effectué après dépôt de 5 couches successives. L'empilement final, constitué de 10 couches, est traité à 700°C pendant 4 heures au four.

4) Imprégnation de l'empilement.

Pour imprégner l'empilement, on utilise la solution sol-gel, dont la préparation est explicitée au point 1). On laisse le substrat immergé dans la solution pendant environ 1 minute. L'imprégnation est réalisée par trempage-retrait à la vitesse de 5 à 10 cm.min$^{-1}$. Après chaque imprégnation, l'on chauffe à 50°C pendant 5 minutes, 360°C pendant 5 minutes et 388°C pendant 10 minutes. Le traitement thermique a lieu sur plaque chauffante pour les revêtements réalisés sur une seule face. Au bout de 4 imprégnations, un traitement à 600°C pendant 10 minutes est réalisé (sur plaque chaufffante et au four). L'opération est répétée jusqu'à obtention de la saturation apparente du film. On considère que les imprégnations sont terminées quand la rugosité du film mesurée au profilomètre et divisée par 10. Dans cet exemple, on réalise 17 imprégnations. L'empilement est finalement recuit à 700°C pendant 4 heures. L'épaisseur totale du film est de 35 $\mu$m.

5) Mesure de $\varepsilon_r$ et $d_{33}$.

Afin de mesurer $\varepsilon_r$ et $d_{33}$, le film obtenu est métallisé avec de l'aluminium par pulvérisation cathodique ou évaporation, l'épaisseur déposée est de 400 $\mu$m (4000 Å).
La mesure de la permittivité relative est réalisée avec un diélectromètre HP4284, à 0 V, 10 kHz et 30 mV. La constante de charge est mesurée après polarisation du film dans un bain d'huile à 90°C sous un champ électrique de 6-9 kV/mm.
Les résultats sont regroupés dans le tableau suivant :

$$\varepsilon_r = 81$$

$$d_{33} = 600 \ pC.N^{-1}$$

EXEMPLE COMPARATIF

La poudre est préparée comme dans l'exemple 1.

1) Préparation de la dispersion.

La poudre est préalablement broyée au mortier avant d'être mélangée à la solution précurseur de PZT telle que préparée dans l'exemple 1. Les proportions sont de 50 :50 en masse. La dispersion est sonifiée sous agitation pendant 20 minutes pour réduire la taille des grains et homogénéiser la solution. Le tout est ensuite placé sous agitation pendant au moins une journée.

2) Formation du matériau piézoélectrique.

On utilise un substrat souple en inox (6*3 cm$^2$) de 200 $\mu$m d'épaisseur. Il est préalablement nettoyé au savon et rincé à l'eau et à l'éthanol.

Le substrat est plaqué sur un support afin de protéger une face.

Le dépôt d'une couche de dispersion est réalisé par la technique de trempage-retrait (dip-coating selon la terminologie anglaise). Pour ce faire, le substrat est trempé pendant 1 minute dans la dispersion précédemment préparée puis retiré à une vitesse de 10 cm.min$^{-1}$. Le substrat revêtu de la couche est ensuite placé sur une plaque chauffante à 50°C pendant 5 minutes puis 360°C pendant 5 minutes. La couche ainsi traitée est ensuite imprégnée, par trempage-retrait, par une solution sol-gel, dont la préparation est explicitée au point 1). Pour ce faire, la couche est immergée dans la solution pendant environ 1 minute puis retirée à une vitesse allant de 5 à 10 cm.min$^{-1}$. L'opération d'imprégnation est réitérée deux fois. Après chaque imprégnation, on chauffe l'échantillon à 50°C pendant 5 minutes, 360°C pendant 5 minutes. Au bout des trois imprégnations, l'on chauffe à 388°C pendant 10 minutes et 600°C pendant 10 minutes.

Le cycle dépôt de couche-imprégnations est répétée 4 fois.

L'empilement final constitué de 5 couches est finalement recuit à 700°C pendant 4 heures.

Parallèllement, un autre essai a été réalisé de manière à obtenir un empilement de deux couches, chaque couche étant imprégnée 4 fois.

3) Mesure de $\varepsilon_r$ et $d_{33}$.

Afin de mesurer $\varepsilon_r$ et $d_{33}$, le film obtenu est métallisé avec de l'aluminium par pulvérisation cathodique ou évaporation, l'épaisseur déposée est de 4000 Å.

La mesure de la permittivité relative est réalisée avec un diélectromètre HP4284, à 0 V, 10 kHz et 30 mV.

La constante de charge est mesurée après polarisation du film dans un bain d'huile à 90°C sous un champ électrique de 6-9 kV/mm. Les résultats sont regroupés dans le tableau suivant :

- pour un empilement de 5 couches avec 3 imprégnations par couche :

$$\varepsilon_r = 141$$

$$d_{33} = 25 \ \mathrm{pC.N}^{-1}$$

- pour un empilement de 2 couches avec 4 imprégnations par couche :

$$\varepsilon_r = 206$$

$$d_{33} = 5 \ \mathrm{pC.N}^{-1}$$

L'on observe ainsi que, lorsque l'imprégnation s'effectue couche par couche, les propriétés piézoélectriques sont bien moins bonnes que celles obtenues, lorsque l'imprégnation s'effectue sur l'empilement complet, tel que cela est démontré dans l'exemple 1.

**Revendications**

1. Procédé de préparation d'un matériau à base de céramique(s) oxyde(s) piézoélectrique(s) comprenant successivement les étapes suivantes :

   a) déposer, par voie liquide, sur au moins une face d'un substrat, une couche d'une dispersion comprenant une poudre de céramique oxyde et une solution sol-gel précurseur d'une céramique oxyde, la poudre de céramique oxyde étant piézoélectrique et/ou la solution sol-gel étant précurseur d'une céramique oxyde piézoélectrique ;
   b) répéter a), une ou plusieurs fois, de manière à obtenir un empilement d'au moins deux couches ;
   c) traiter thermiquement lesdites couches en vue de les transformer en la (les) céramique(s) correspondante(s) ;
   d) imprégner par trempage-retrait l'empilement obtenu en c) par une solution sol-gel identique ou différente de celle utilisée dans l'étape a) ;
   e) répéter l'étape d) une ou plusieurs fois ;
   f) traiter thermiquement ledit empilement, en vue de transformer la solution sol-gel imprégnant l'empilement en la céramique correspondante.

2. Procédé selon la revendication 1, dans lequel le substrat est en un matériau choisi parmi l'acier inoxydable, l'acier comprenant du nickel, le silicium éventuellement platiné, l'aluminium, 1' alumine, le titane ou le carbone.

3. Procédé selon la revendication 1 ou 2, comprenant, en outre, avant l'étape a), le dépôt d'une couche barrière sur la ou les faces du substrat, cette couche étant en un matériau choisi parmi SiO$_2$, Ta$_2$O$_5$, ZrO$_2$, Al$_2$O$_3$, TiO$_2$, PZT, BST et des combinaisons de ceux-ci.

4. Procédé selon l'une quelconque des revendications 1 à 3, dans lequel la poudre de céramique oxyde est présente dans la dispersion à une teneur pouvant aller jusqu'à 80% en poids du poids total de la dispersion.

5. Procédé selon l'une quelconque des revendications 1 à 4, dans lequel la poudre de céramique oxyde est présente dans la dispersion à une teneur allant de 10 à 60% en poids du poids total de la dispersion.

6. Procédé selon l'une quelconque des revendications 1 à 5, dans lequel la poudre de céramique oxyde présente un diamètre moyen de particules allant de 10 nm à 100 $\mu$m.

7. Procédé selon l'une quelconque des revendications précédentes, dans lequel le dépôt de l'étape a) se fait par trempage-retrait.

8. procédé selon l'une quelconque des revendications 1 à 7, dans lequel le traitement thermique mis en oeuvre en c) comprend successivement les étapes suivantes :

   - une étape de séchage de chaque couche déposée à une température appropriée pour obtenir une gélification de celle-ci ;
   - une étape de calcination de chaque couche déposée à une température appropriée pour obtenir une élimination des produits organiques compris dans la couche ;
   - une étape de recuit de chaque couche déposée à une température appropriée pour obtenir une cristallisation en céramique oxyde de la couche.

9. Procédé selon l'une quelconque des revendications 1 à 7, dans lequel le traitement thermique mis en oeuvre en c) comprend successivement les étapes suivantes :

   - une étape de séchage de chaque couche déposée à une température appropriée pour obtenir une gélification de celle-ci ;
   - une étape de calcination de chaque couche déposée à une température appropriée pour obtenir une élimination des produits organiques compris dans la Couche :
   - une étape de recuit toutes les n couches déposées, n allant de 2 jusqu'au nombre total de couches déposées, ledit recuit étant réalisé à une température appropriée pour obtenir une cristallisation en céramique oxyde des couches.

10. Procédé selon l'une quelconque des revendications 1 à 9, dans lequel le matériau en céramique(s) oxyde(s) piézoélectrique(s) est un matériau choisi parmi le zirconc-titanate de plomb (intitulé PZT), le titanate de baryum et de strontium (intitulé BST), le titanate de plomb, de niobium et de zinc (intitulé PZNT), le niobate de magnésium et de plomb (intitulé PMN), le titanate de plomb (intitulé PT), le niobate de potassium et de calcium, le titanate de bismuth et de potassium (intitulé BKT), le titanate de bismuth et de strontium (intitulé SBT).

11. Procédé selon la revendication 10, dans lequel le matériau en céramique oxyde piézoélectrique est le zircano-titanate de plomb (PZT).

12. Procédé selon la revendication 10, dans lequel la solution sol-gel précurseur de PZT compris dans la dispersion de l'étape a) est identique à celle utilisée pour l'imprégnation de l'étape c).

13. Procédé selon la revendication 12, dans lequel la solution sol-gel précurseur de PZT de la dispersion utilisée dans l'étape a) et servant pour l'imprégnation de l'étape c) est issue d'un procédé comprenant successivement les étapes suivantes :

   - préparer, dans un milieu organique comprenant un solvant diol, une solution sol-gel précurseur d'une céramique PZT ;
   - laisser au repos la solution préparée précédemment pendant un temps suffisant nécessaire à l'obtention d'une solution présentant une viscosité sensiblement constante en fonction du temps ;
   - diluer la solution ainsi obtenue à un taux prédéterminé de dilution avec le même solvant diol que celui utilisé dans la première étape ou un solvant différent miscible avec le solvant diol utilisé dans l'étape de préparation.

**Claims**

1. Process for preparing material based on one or more piezoelectric oxide ceramics, which comprises, in succession, the following steps:

   a) deposition by a liquid route, on at least one face of a substrate, of a layer of a dispersion comprising a powder of an oxide ceramic and a sol-gel solution as precursor of an oxide ceramic, the oxide ceramic powder being piezoelectric and/or the sol-gel solution being a precursor of a piezoelectric oxide ceramic;
   b) repetition of step a), one or more times, so as to obtain a multilayer film consisting of at least two layers;
   c) heat treatment of said layers for the purpose of converting them into the corresponding ceramic(s);
   d) impregnation of the multilayer film obtained at step c) by dip coating it with a sol-gel solution identical to or different from that used in step a);

e) repetition of step d) one or more times; and

f) heat treatment of said multilayer film, for the purpose of converting the sol-gel solution impregnating the multilayer film into the corresponding ceramic.

2. Process according to Claim 1, in which the substrate is a material chosen from: stainless steel; steel containing nickel; silicon, optionally platinized; aluminium; alumina; titanium; or carbon.

3. Process according to Claim 1 or 2, which further includes, before step a), the deposition of a barrier layer on one or both faces of the substrate, this layer being made of a material chosen from $SiO_2$, $Ta_2O_5$, $ZrO_2$, $Al_2O_3$, $TiO_2$, PZT, BST and combinations thereof.

4. Process according to any one of Claims 1 to 3, in which the oxide ceramic powder is present in the dispersion with a content possibly ranging up to 80% by weight relative to the total weight of the dispersion.

5. Process according to any one of Claims 1 to 4, in which the oxide ceramic powder is present in the dispersion with a content ranging from 10 to 60% by weight relative to the total weight of the dispersion.

6. Process according to any one of Claims 1 to 5, in which the oxide ceramic powder has a mean particle diameter ranging from 10 nm to 100 $\mu$m.

7. Process according to any one of the preceding claims, in which the deposition of step a) is carried out by dip coating.

8. Process according to any one of Claims 1 to 7, in which the heat treatment carried out in step c) comprises, in succession, the following steps:

- a step of drying each deposited layer at a temperature suitable for causing gelation of said layer;
- a step of calcining each deposited layer at a temperature suitable for eliminating the organic substances within the layer; and
- a step of annealing each deposited layer at a temperature suitable for crystallizing the layer as an oxide ceramic.

9. Process according to any one of Claims 1 to 7, in which the heat treatment carried out in step c) comprises, in succession, the following steps:

- a step of drying each deposited layer at a temperature suitable for causing gelation of said layer;

- a step of calcining each deposited layer at a temperature suitable for eliminating the organic substances within the layer; and
- a step of annealing all the n layers deposited, n ranging from 2 up to the total number of layers deposited, said annealing being carried out at a temperature suitable for crystallizing the layers as an oxide ceramic.

10. Process according to any one of Claims 1 to 9, in which the piezoelectric oxide ceramic material is a material chosen from lead zirconate titanate (PZT), barium strontium titanate (BST), lead niobium zinc titanate (PZNT), lead magnesium niobate (PMN), lead titanate (PT), potassium calcium niobate, bismuth potassium titanate (BKT) and strontium bismuth titanate (SBT).

11. Process according to Claim 10, in which the piezoelectric oxide ceramic material is lead zirconate titanate (PZT).

12. Process according to Claim 10, in which the PZT precursor sol-gel solution constitutes the dispersion of step a) is identical to that used for the impregnation of step c).

13. Process according to Claim 12, in which the PZT precursor sol-gel solution of the dispersion used in step a) and serving for the impregnation of step C) results from a process comprising, in succession, the following steps:

- a sol-gel solution as precursor of a PZT ceramic is prepared in an organic medium comprising a diol solvent;
- the solution prepared above is left to stand for a sufficient time needed to obtain a solution having a viscosity that remains substantially constant over time; and
- the solution thus obtained is diluted to a predetermined level of dilution with the same diol solvent as that used in the first step or a different solvent which is miscible with the diol solvent used in the preparation step.

**Patentansprüche**

1. Verfahren zur Herstellung eines Materials auf der Grundlage einer piezoelektrischen (piezoelektrischer) Oxidkeramik(en), das nacheinander die folgenden Schritte umfasst:

a) Abscheiden auf nassem Weg auf wenigstens einer Fläche eines Substrats einer Schicht aus einer Dispersion, die ein Oxidkeramikpulver und eine Sol-Gel-Lösung eines Oxidkeramikvorläufers umfasst, wobei das Oxidkeramikpulver piezoelektrisch ist und/oder die Sol-Gel-Lösung Vorläufer einer piezoelektrischen Oxidkeramik ist;

b) ein- oder mehrmaliges Wiederholen von a), um einen Stapel von wenigstens zwei Schichten zu erhalten;

c) Wärmebehandlung dieser Schichten mit dem Ziel, sie in die entsprechende(n) Keramik(en) umzuwandeln;

d) Tränken des in c) erhaltenen Stapels mit einer zu der in Schritt a) verwendeten identischen oder verschiedenen Sol-Gel-Lösung durch Tauchbeschichtung;

e) ein- oder mehrmaliges Wiederholen des Schritts d);

f) Wärmebehandlung des Stapels mit dem Ziel, die den Stapel durchtränkende Sol-Gel-Lösung in die entsprechende Keramik umzuwandeln.

2. Verfahren gemäß Anspruch 1, bei dem das Substrat aus einem aus Edelstahl, nickelhaltigem Stahl, gegebenenfalls platinhaltigem Silizium, Aluminium, Aluminiumoxid, Titan oder Kohlenstoff ausgewählten Material besteht.

3. Verfahren gemäß Anspruch 1 oder 2, das außerdem vor dem Schritt a) die Abscheidung einer Sperrschicht auf der oder den Flächen des Substrats umfasst, wobei diese Schicht aus einem aus $SiO_2$, $Ta_2O_5$, $ZrO_2$, $Al_2O_3$, $TiO_2$, PZT, BST und deren Kombinationen ausgewählten Material besteht.

4. Verfahren gemäß einem der Ansprüche 1 bis 3, bei dem das Oxidkeramikpulver in der Dispersion in einem Gehalt vorliegt, der bis zu 80 Gew.-% des Gesamtgewichts der Dispersion reichen kann.

5. Verfahren gemäß einem der Ansprüche 1 bis 4, bei dem das Oxidkeramikpulver in der Dispersion in einem Gehalt vorliegt, der von 10 bis 60 Gew.-% des Gesamtgewichts der Dispersion reichen kann.

6. Verfahren gemäß einem der Ansprüche 1 bis 5, bei dem das Oxidkeramikpulver einen mittleren Teilchendurchmesser von 10 nm bis 100 $\mu$m aufweist.

7. Verfahren gemäß einem der vorangehenden Ansprüche, bei dem die Abscheidung des Schritts a) durch Tauchbeschichtung erfolgt.

8. Verfahren gemäß einem der Ansprüche 1 bis 7, bei dem die in c) eingesetzte Wärmebehandlung nacheinander die folgenden Schritte umfasst:

- einen Schritt des Trocknens jeder abgeschiedenen Schicht bei einer zu ihrer Gelierung geeigneten Temperatur;

- einen Schritt der Kalzinierung jeder abgeschiedenen Schicht bei einer zum Entfernen von der Schicht umfasster organischer Produkte geeigneten Temperatur;

- einen Schritt des Temperns jeder abgeschiedenen Schicht bei einer zur Kristallisation der Schicht als Oxidkeramik geeigneten Temperatur.

9. Verfahren gemäß einem der Ansprüche 1 bis 7, bei dem die in c) eingesetzte Wärmebehandlung nacheinander die folgenden Schritte umfasst:

- ein Schritt des Trocknens jeder abgeschiedenen Schicht bei einer zu ihrer Gelierung geeigneten Temperatur;

- einen Schritt der Kalzinierung jeder abgeschiedenen Schicht bei einer zum Entfernen von der Schicht umfasster organischer Produkte geeigneten Temperatur;

- einen Schritt des Temperns aller n abgeschiedenen Schichten, wobei n von 2 bis zur Gesamtzahl der abgeschiedenen Schichten reicht und dieses Tempern bei einer zur Kristallisation der Schichten als Oxidkeramik geeigneten Temperatur durchgeführt wird.

10. Verfahren gemäß einem der Ansprüche 1 bis 9, bei dem das Material aus piezoelektrischer (piezoelektrischen) Oxidkeramik(en) ein Material ist, das aus Bleizirkonattitanat (PZT genannt), Bariumstrontiumtitanat (BST genannt), Bleiniobiumzinktitanat (PZNT genannt), Magnesiumbleiniobat (PMN genannt), Bleititanat (PT genannt), Kaliumcalciumniobat, Bismutkaliumtitanat (BKT genannt) und Bismutstrontiumtitanat (SBT genannt) ausgewählt ist.

11. Verfahren gemäß Anspruch 10, bei dem das Material aus piezoelektrischer Oxidkeramik Bleizirkonattitanat (PZT) ist.

12. Verfahren gemäß Anspruch 10, bei dem die in der Dispersion von Schritt a) umfasste Sol-Gel-Lösung des PZT-Vorläufers mit der von Schritt c) zum Tränken verwendeten identisch ist.

13. Verfahren gemäß Anspruch 12, bei dem die in der Dispersion von Schritt a) umfasste Sol-Gel-Lösung des PZT-Vorläufers, die in Schritt c) zum Tränken verwendet wird, aus einem Verfahren herrührt, das nacheinander die folgenden Schritte umfasst:

- Herstellen einer Sol-Gel-Lösung eines PZT-Keramikvorläufers in einem organischen Medium;

- Ruhenlassen der vorstehend hergestellten Lösung während eines zum Erhalt einer Lösung, die eine im Wesentlichen zeitlich konstante Viskosität aufweist, notwendigen Zeitraums;
- Verdünnen der so erhaltenen Lösung auf einen vorbestimmten Verdünnungsgrad mit demselben Diollösungsmittel, das im ersten Schritt verwendet wurde oder einem unterschiedlichen Lösungsmittel, das mit dem im Herstellungsschritt verwendeten Diollösungsmittel mischbar ist.

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **R.A. DOREY et al.** Effect of sintering aid and repeated sol infiltrations on the dielectric and piezoelectric properties of a PZT composite thick film. *Journal of the European Ceramic Society,* 2002, vol. 22, 2921-2926
- **A.L. KHOLKIN et al.** PZT-based composites via a modified sol-gel route. *Journal of the European Ceramic Society,* 2001, vol. 21, 1535-1538
- **F.F.C. DUVAL et al.** Lead germanium oxide sinter-assisted PZT composite thick films. *Journal of the European Ceramic Society,* 2003, vol. 23, 1935-1941
- **D.A BARROW et al.** *Surface and Coatings Technology,* 1995, vol. 76-77, 113-118
- **DOREY et al.** *Integrated Ferroelectrics,* 2002, vol. 50, 111-119